(19) Europäisches Patentamt / European Patent Office / Office européen des brevets

(11) **EP 4 071 491 B1**

(12) **FASCICULE DE BREVET EUROPEEN**

(45) Date de publication et mention de la délivrance du brevet:
**20.12.2023 Bulletin 2023/51**

(21) Numéro de dépôt: **22167290.0**

(22) Date de dépôt: **08.04.2022**

(51) Classification Internationale des Brevets (IPC):
**G01R 31/367** *(2019.01)*   **G01R 31/374** *(2019.01)*
**G01R 31/392** *(2019.01)*

(52) Classification Coopérative des Brevets (CPC):
**G01R 31/374; G01R 31/367; G01R 31/392**

(54) **PROCÉDÉ ET DISPOSITIF DE CALCUL DE CAPACITÉ D'UN MODULE DE FOURNITURE D ÉNERGIE ÉLECTRIQUE**

VERFAHREN UND VORRICHTUNG ZUR BERECHNUNG DER KAPAZITÄTEN EINES MODULS ZUR LIEFERUNG VON ELEKTRISCHER ENERGIE

METHOD AND DEVICE FOR CALCULATING CAPACITY OF A MODULE FOR SUPPLYING ELECTRICAL ENERGY

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **09.04.2021 FR 2103651**

(43) Date de publication de la demande:
**12.10.2022 Bulletin 2022/41**

(73) Titulaire: **Lacroix Group**
**44800 Saint Herblain (FR)**

(72) Inventeur: **HOUDANT, Igor**
**35230 BOURGBARRE (FR)**

(74) Mandataire: **Lavoix**
**62, rue de Bonnel**
**69448 Lyon Cedex 03 (FR)**

(56) Documents cités:
**FR-A1- 2 971 855      FR-A1- 3 077 450**
**US-A1- 2002 169 572**

EP 4 071 491 B1

**Description**

La présente invention concerne un procédé et un dispositif de calcul de capacité d'un module de fourniture d'énergie électrique, ledit module étant une pile ou une batterie électrique, ledit module de fourniture d'énergie électrique étant intégré dans un équipement électronique.

L'invention se situe dans le domaine de l'alimentation en énergie électrique d'équipements électroniques, et plus particulièrement dans le domaine de la surveillance de la capacité de fourniture d'énergie électrique.

L'invention trouve des applications notamment dans le domaine des objets industriels connectés en réseau de communications, connu sous le nom de IIoT (pour « Industrial Internet of Things »), utilisés dans des installations industrielles, domotiques ou domestiques.

De manière connue, pour une alimentation électrique autonome on utilise des piles électriques ou des batteries rechargeables, appelés modules de fourniture d'énergie électrique dans ce qui suit.

Une pile électrique est, de manière connue, un dispositif électrochimique qui convertit de l'énergie chimique en énergie électrique, grâce à une réaction d'oxydoréduction. Une batterie est un générateur électrique de tension, qui est rechargeable, permettant de stocker de l'énergie électrique sous forme chimique et de la restituer sous forme de courant continu.

De tels modules de fourniture d'énergie électrique sont adaptés à alimenter tout type d'équipement électronique.

De manière connue, un module de fourniture d'énergie électrique a une capacité énergétique qui définit la quantité d'énergie stockée dans le module, et qui se mesure en général en watt-seconde (Ws) ou en watt-heure (Wh). Un tel module de fourniture d'énergie électrique a également une capacité électrique, exprimée en Ampère-heure (Ah), qui définit la quantité maximale de charge électrique qu'il peut fournir au cours de son utilisation.

De manière classique, une capacité énergétique et/ou une capacité électrique initiales sont définies par le fabricant d'un tel module de fourniture électrique, pour une température nominale d'utilisation, par exemple 20°C.

Pour divers équipements électroniques alimentés par un tel module, il est utile de connaître la capacité énergétique ou électrique résiduelle dans le module au fur et à mesure de son utilisation, notamment pour prévenir d'éventuelles pannes et pour effectuer une maintenance prédictive, par exemple un changement de pile ou une recharge de la batterie.

Dans la suite, on utilisera le terme capacité d'un module de fourniture d'énergie électrique pour désigner la capacité électrique résiduelle de ce module en cours d'utilisation.

Bien entendu, la capacité d'un module de fourniture d'énergie électrique dépend de la consommation d'énergie électrique durant des cycles d'utilisation, cette consommation pouvant être mesurée ou estimée au fur et à mesure de son utilisation.

Cependant, la température d'utilisation d'un module de fourniture d'énergie, pile ou batterie électrique, a un effet sur les caractéristiques de fonctionnement, en particulier de fourniture d'énergie électrique. En d'autres termes, la décharge d'un tel module de fourniture d'énergie électrique, et donc sa capacité résiduelle après un cycle ou une période d'utilisation, dépend de la température.

Selon une méthode connue, une moyenne de température d'utilisation durant un cycle temporel est calculée, et un facteur de correction dépendant de la température moyenne est appliqué dans le calcul de capacité. Cependant, si le cycle temporel est relativement long, par exemple de 24 heures, la moyenne arithmétique de la température masque d'éventuelles variations importantes de température, et donc le calcul de capacité se trouve faussé. Il a également été proposé de relever des températures extrêmes, minimale et maximale, et d'utiliser des facteurs de correction dépendants de ces températures. Cependant les températures extrêmes peuvent être ponctuelles, et donc le calcul de capacité ainsi obtenu manque de précision.

FR 3 077 450 A1 divulgue un procédé de calcul de capacité d'un module de fourniture d'énergie électrique, ledit module étant une pile ou une batterie électrique, ledit module de fourniture d'énergie électrique étant intégré dans un équipement électronique, ledit équipement électronique comportant ou étant adapté pour recevoir des mesures de température d'un capteur de température.

L'invention a pour objet de remédier aux inconvénients de l'état de la technique, en proposant un procédé de calcul de capacité d'un module de fourniture d'énergie électrique qui soit plus précis.

A cet effet, l'invention propose, selon un aspect, un procédé de calcul de capacité d'un module de fourniture d'énergie électrique, ledit module étant une pile ou une batterie électrique, ledit module de fourniture d'énergie électrique étant intégré dans un équipement électronique, ledit équipement électronique comportant ou étant adapté pour recevoir des mesures de température d'un capteur de température. Ce procédé comporte des étapes, mises en oeuvre par un processeur de calcul, de :

- sur une période temporelle de surveillance prédéterminée, obtention d'une pluralité de mesures de température, et pour chaque mesure de température, calcul d'un coefficient d'impact de capacité électrique en fonction d'un modèle pré-enregistré, et mémorisation dudit coefficient d'impact de capacité électrique calculé ;

- calcul d'un coefficient global d'impact de capacité électrique sur la période temporelle de surveillance à partir desdits coefficients d'impact de capacité électrique mémorisés ;
- calcul d'une capacité résiduelle du module de fourniture d'énergie électrique à partir d'une capacité électrique consommée, mesurée ou estimée sur ladite période temporelle de surveillance, ce calcul tenant compte dudit coefficient global calculé.

Avantageusement, la mise en oeuvre d'une pluralité de coefficients d'impact de capacité électrique, chaque coefficient d'impact étant calculé pour une température mesurée, permet de calculer avec une meilleure précision la capacité du module de fourniture d'énergie

Le procédé de calcul de capacité d'un module de fourniture d'énergie électrique selon l'invention peut également présenter une ou plusieurs des caractéristiques ci-dessous, prises indépendamment ou selon toutes les combinaisons techniquement envisageables.

Le calcul du coefficient global d'impact de capacité électrique sur la période temporelle de surveillance met en oeuvre un calcul de valeur moyenne desdits coefficients d'impact de capacité électrique mémorisés.

Le calcul d'une capacité résiduelle comprend un calcul de capacité électrique consommée corrigée à partir de la capacité électrique consommée mesurée ou estimée et du coefficient global d'impact de capacité électrique.

Chaque coefficient d'impact de capacité électrique est représentatif d'un pourcentage de perte de capacité électrique du module de fourniture d'énergie électrique en fonction de la température.

Le modèle pré-enregistré est calculé à partir de caractéristiques de fonctionnement du module de fourniture d'énergie électrique.

Le procédé comporte une prise en compte d'un profil d'utilisation dudit module de fourniture d'énergie électrique, un modèle associant des coefficients d'impact de capacité électrique et des valeurs de température étant enregistré pour chaque profil d'utilisation considéré.

Le modèle pré-enregistré comprend au moins une fonction mathématique définissant le coefficient d'impact de capacité électrique en fonction de la température.

Ce modèle est obtenu par une interpolation polynomiale de valeurs de coefficients d'impact de capacité électrique échantillonnées sur une plage de température d'utilisation prévue.

Le procédé comprend en outre une étape de traitement comprenant une commande d'affichage d'une information relative à la capacité résiduelle du module de fourniture d'énergie électrique sur une interface homme-machine d'un dispositif électronique.

L'étape de traitement comporte en outre une vérification d'atteinte d'un niveau plancher de capacité résiduelle, et l'émission d'une alerte en cas d'atteinte dudit niveau plancher.

Selon un autre aspect, l'invention concerne un dispositif de calcul de capacité d'un module de fourniture d'énergie électrique, ledit module étant une pile ou une batterie électrique, ledit module de fourniture d'énergie électrique étant intégré dans un équipement électronique, ledit équipement électronique comportant ou étant adapté pour recevoir des mesures de température d'un capteur de température. Ce dispositif comporte un processeur de calcul configuré pour mettre en oeuvre :

- sur une période temporelle de surveillance prédéterminée, un module d'obtention d'une pluralité de mesures de température, et pour chaque mesure de température, un module de calcul d'un coefficient d'impact de capacité électrique en fonction d'un modèle pré-enregistré, et de mémorisation dudit coefficient d'impact de capacité électrique calculé ;
- un module de calcul d'un coefficient global d'impact de capacité électrique sur la période temporelle de surveillance à partir desdits coefficients d'impact de capacité électrique mémorisés ;
- un module de calcul d'une capacité résiduelle du module de fourniture d'énergie électrique à partir d'une capacité électrique consommée, mesurée ou estimée sur ladite période temporelle de surveillance, le calcul tenant compte dudit coefficient global calculé.

Le dispositif de calcul de capacité d'un module de fourniture d'énergie électrique est configuré pour mettre en oeuvre le procédé de calcul de capacité d'un module de fourniture d'énergie électrique brièvement décrit ci-dessus selon tous ses modes de réalisation.

Selon une caractéristique particulière, le dispositif comprend en outre un module de traitement de capacité résiduelle du module de fourniture d'énergie électrique, configuré pour commander un d'affichage d'une information relative à la capacité résiduelle du module de fourniture d'énergie électrique sur une interface homme-machine d'un dispositif électronique et/ou pour vérifier l'atteinte d'un niveau plancher de capacité résiduelle, et pour envoyer une alerte en cas d'atteinte dudit niveau plancher.

Selon un autre aspect, l'invention concerne un programme d'ordinateur comportant des instructions logicielles, qui, lorsqu'elles sont exécutées par un dispositif électronique programmable, exécutent un procédé de calcul de capacité d'un module de fourniture d'énergie électrique tel que brièvement décrit ci-dessus.

D'autres caractéristiques et avantages de l'invention ressortiront de la description qui en est donnée ci-dessous, à titre indicatif et nullement limitatif, en référence aux figures annexées, parmi lesquelles :

[Fig 1] la figure 1 est une vue schématique d'un dispositif de calcul de capacité d'un module de fourniture d'énergie électrique dans un cas d'application;

[Fig 2] la figure 2 est un synoptique des principales étapes d'un procédé de calcul de capacité d'un module de fourniture d'énergie électrique dans un mode de réalisation.

L'invention sera décrite ci-après dans son application pour le calcul de capacité d'un module de fourniture d'énergie intégré dans un équipement électronique de surveillance de fonctionnement d'une installation. L'installation est par exemple un réseau de distribution de fluide, e.g. d'eau ou de gaz.

Bien entendu, l'invention ne se limite pas à ce cas d'application et s'applique de manière générale dans tout équipement électronique intégrant un module de fourniture d'énergie électrique.

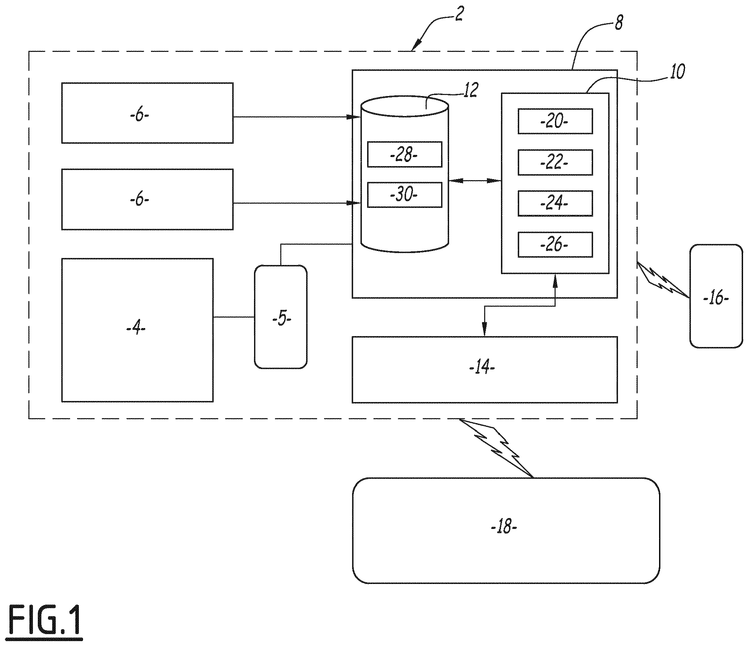

La figure 1 illustre schématiquement un équipement 2, qui est par exemple un équipement électronique de surveillance de fonctionnement d'une installation (non représentée), configuré pour recueillir des données et les transmettre, par des moyens de communication adaptés, à des dispositifs électroniques distants.

L'équipement 2 comprend un module de fourniture d'énergie électrique 4, qui est par exemple une pile électrique ou une batterie rechargeable.

Le module 4 est adapté à fournir de l'énergie électrique aux différents composants de l'équipement 2.

En particulier, l'équipement 2 comprend ou est connecté à des capteurs 6, adaptés pour relever des mesures de paramètres physiques de l'environnement de l'équipement 2.

Dans l'exemple de la figure 1, deux tels capteurs 6 sont représentés. Ces capteurs portent le même numéro de référence, mais peuvent être de natures différentes, en particulier adaptés à mesurer des paramètres physiques différents. Bien entendu, le nombre de capteurs est quelconque.

En particulier, un des capteurs 6 est un capteur de température, adapté à fournir des mesures de température, par exemple à des intervalles de temps réguliers. Un des capteurs 6 relève la température du module de fourniture d'énergie électrique 4.

Par exemple, un autre capteur est un capteur de pression ou d'hygrométrie.

Dans un mode de réalisation, les capteurs 6 sont alimentés en électricité par le module de fourniture d'énergie électrique 4.

L'équipement 2 comporte également un dispositif électronique de calcul 8, qui est alimenté électriquement par le module de fourniture d'énergie électrique 4.

Le dispositif électronique de calcul 8 comprend un processeur 10 et une unité de mémoire électronique 12 qui sont adaptés à communiquer via un bus de communication interne.

L'équipement 2 comprend également une interface de communication 14, adaptée pour mettre en oeuvre un protocole de communication, par exemple un protocole de communication filaire, ou un protocole de communication radio pour réaliser une communication, filaire ou sans fil, avec des dispositifs électroniques distants 16, 18.

Ainsi, l'équipement 2 est un dispositif connecté à un réseau de communication.

Dans un exemple d'application, le dispositif électronique 16 est par exemple un terminal d'utilisateur (e.g. tablette, « smartphone »), qui comporte une interface homme-machine permettant l'affichage d'informations ou d'alertes. En particulier, via une telle interface homme-machine il est possible de prévenir un utilisateur de la capacité résiduelle du module de fourniture d'énergie électrique 4, par exemple d'une durée d'utilisation restante.

Dans un exemple d'application, le dispositif électronique 18 est un équipement central d'un centre de supervision, qui reçoit des informations et traite ces informations à l'intention par exemple d'un exploitant de l'installation à laquelle appartient l'équipement 2.

Dans un mode de réalisation, les informations relatives à la capacité du module de fourniture d'énergie électrique 4 sont transmises au dispositif électronique 18 qui centralise ces informations, et commande des affichages et/ou des alertes le cas échéant.

Le processeur 10 est configuré pour mettre en oeuvre un module 20 de calcul d'un coefficient d'impact de capacité électrique en fonction d'un modèle 28 pré-enregistré. Le module 20 est configuré pour obtenir des mesures de température en provenance d'un capteur de température 6, un coefficient d'impact de capacité électrique étant calculé en fonction d'une mesure de température et du modèle 28.

Le calcul est effectué pour une pluralité de mesures de température $T_n$ relevées durant une période temporelle de surveillance prédéterminée, de durée $\Delta T$ par exemple égale à 1 jour. Par exemple les mesures de température sont effectuées à des intervalles dt, par exemple dt est égal à 1 heure, et pour chaque mesure de température $T_n$, un coefficient d'impact de capacité électrique $K(T_n)$ est calculé et mémorisé dans une structure de mémoire 30 de l'unité de mémoire électronique 12.

Le processeur 10 est en outre configuré pour mettre en oeuvre un module 22 de calcul d'un coefficient global $K(\Delta T)$ d'impact de capacité électrique sur la période temporelle de surveillance à partir desdits coefficients $K(T_n)$ de modification de la consommation électrique mémorisés.

Le processeur 10 est en outre configuré pour mettre en oeuvre un module 24 de calcul d'une capacité du module de fourniture d'énergie électrique, qui est la capacité résiduelle après la période temporelle de surveillance écoulée, à partir d'une capacité électrique consommée, mesurée ou estimée, sur la période temporelle de surveillance, en tenant compte dudit coefficient global $K(\Delta T)$ calculé.

Enfin, le processeur 10 est configuré pour mettre en oeuvre un module 26 de traitement de la capacité résiduelle du module de fourniture d'énergie électrique calculée, le traitement comprenant par exemple une commande d'affichage d'une information relative à cette capacité calculée et/ou un envoi d'alerte pour signaler qu'un niveau plancher de capacité résiduelle est atteint.

Dans un mode de réalisation, les modules 20, 22, 24 et 26 sont réalisés sous forme d'instructions de code exécutable et forment un programme d'ordinateur (ou logiciel) adapté pour mettre en oeuvre un procédé de calcul de capacité d'un module de fourniture d'énergie électrique lorsqu'il est exécuté par un dispositif électronique programmable.

Dans un mode de réalisation, ce programme d'ordinateur est mémorisé sur un support d'informations lisible par un dispositif électronique programmable. A titre d'exemple, le support lisible est un disque optique, un disque magnéto-optique, une mémoire ROM, une mémoire RAM, tout type de mémoire non-volatile (par exemple EPROM, EEPROM, FLASH, NVRAM), une carte magnétique ou une carte optique.

En variante non représentée, ces modules sont réalisés sous forme de circuit intégré dédié, tel qu'un ASIC (de l'anglais *Application Spécifie Integrated Circuit*).

L'équipement 2 comporte en outre un circuit de surveillance 5, connecté entre le module de fourniture d'énergie électrique 4 et le dispositif électronique de calcul 8. Le circuit de surveillance 5 est adapté pour mesurer le courant consommé ou absorbé par le module 4 et fournir cette mesure au dispositif électronique de calcul 8.Par exemple le circuit de surveillance est un "Coulomb counter", une variante pouvant être un circuit "Gas gauge".

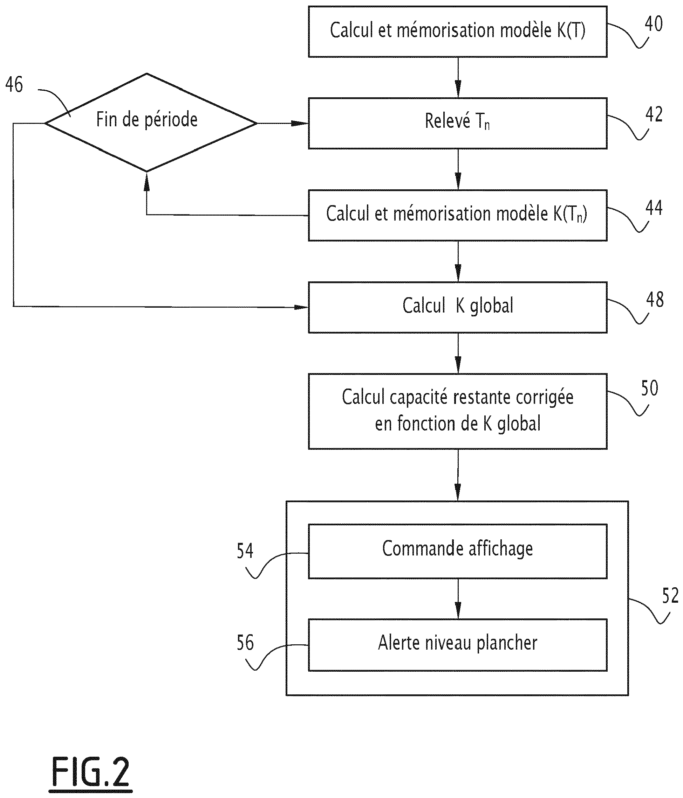

La figure 2 est un synoptique des principales étapes d'un procédé de calcul de capacité d'un module de fourniture d'énergie électrique dans un mode de réalisation de l'invention.

Le procédé comprend une étape préalable 40 de mise au point et de mémorisation d'un modèle représentatif de l'évolution d'un coefficient d'impact de capacité électrique d'un module 4 de fourniture d'énergie électrique en fonction de la température.

Par exemple, un tel modèle est établi en fonction de caractéristiques de fonctionnement du module 4 de fourniture d'énergie électrique, en particulier en fonction de caractéristiques physico-chimiques. Dans un mode de réalisation, le modèle est calculé en fonction de données fournies par le fabricant de ce module.

Par exemple, le module 4 de fourniture d'énergie électrique est une pile lithium-dioxyde de manganèse (Li-MnOs) ou lithium-chlorure de thionyle (Li-SOCl₂) 3,6V et 13Ah.

Dans un mode de réalisation, le coefficient d'impact de capacité électrique est représentatif d'un pourcentage de perte de capacité : il est égal à 0% lorsqu'il n'y a pas de perte de capacité due à la température et il est égal 100% lorsque la capacité de fourniture d'énergie électrique du module 4 de fourniture d'énergie électrique est divisée par 2.

Dans un mode de réalisation, à l'étape 40, à partir de données relatives à la durée de fonctionnement d'une pile en fonction de la température d'utilisation, échantillonnées sur une plage d'utilisation prévue, par exemple tous les d°C de température avec d compris entre 1°C et 10°C, une courbe constituée d'un ensemble de points est obtenue, et une modélisation mathématique est appliquée, par exemple par une interpolation, pour reprendre fidèlement le comportement de la pile.

Par exemple, une interpolation polynomiale est calculée, avec une fonction polynôme de degré choisi, par exemple du 3ème degré. Alternativement, une autre fonction mathématique permettant d'interpoler les valeurs échantillonnées fournies est appliquée.

Selon une autre variante, le modèle est enregistré sous forme de table de correspondance entre des valeurs de température et des valeurs de coefficient d'impact de capacité électrique, par exemple pour des valeurs de température $T_i$ échantillonnées tous les 5 à 10 degrés Celsius. Dans cette variante, pour une valeur de température mesurée $T_k$, le coefficient d'impact $K(T_k)$ est calculé en fonction des valeurs enregistrées $K(T_i)$ et $K(T_{i+1})$, où $T_i<T_k<T_{i+1}$, par exemple en appliquant une interpolation linéaire.

En complément, combinable avec les variantes décrites précédemment, outre les données fournies par le fabricant, le modèle peut prendre en considération des conditions d'utilisation prévues, par exemple un profil d'utilisation de la pile en fonction de l'utilisation de l'équipement 2 auquel elle fournit de l'énergie. Par exemple un premier profil d'utilisation indique une décharge constante de la pile, par exemple à puissance constante, et un deuxième profil des décharges sur des courtes durées, entrecoupées de périodes d'inactivité. Dans ce cas, pour chaque profil d'utilisation, un modèle est calculé et enregistré.

Le procédé comprend une étape 42 d'obtention d'une mesure de température $T_n$, obtenue d'un capteur de température, lorsque l'équipement 2 est en fonctionnement. La mesure de température est effectuée à un instant temporel n d'une période temporelle de surveillance de durée ∆T. Par exemple la période temporelle de surveillance est de 24 heures, et le relevé de température est effectué toutes les heures. Bien entendu, toute autre valeur de périodicité est envisageable.

L'étape 42 est suivie d'une étape 44 de calcul d'un coefficient d'impact $K(T_n)$ de capacité électrique en fonction de la température $T_n$ et du modèle pré-enregistré. Ce coefficient $K(T_n)$ est mémorisé.

Il est ensuite vérifié à l'étape de vérification 46 si la fin de la période temporelle de surveillance est atteinte. En cas de réponse négative, les étapes 42 et 44 sont répétées pour un instant temporel suivant, par exemple décalé d'un intervalle dt=1heure de l'instant temporel précédent.

En cas de réponse positive à l'étape de vérification 46, donc si la fin de la période temporelle de surveillance a été atteinte, un coefficient global d'impact de capacité électrique sur la période temporelle de surveillance est calculé à l'étape de calcul de coefficient global 48.

Par exemple, une moyenne arithmétique des coefficients d'impact de capacité électrique $K(T_n)$ enregistrés est effectuée :

[MATH 1]

$$K(\Delta T) = \frac{1}{N} \sum_{n=1}^{N} K(T_n)$$

Avantageusement, un tel calcul est simple et rapide, et le coefficient global $K(\Delta T)$ calculé est représentatif pour obtenir la capacité électrique réellement dépensée qui n'est pas simplement la capacité électrique consommée sur la période temporelle de surveillance.

Une étape 50 de calcul d'une capacité résiduelle du module de fourniture d'énergie électrique est mise en oeuvre. Ce calcul utilise le coefficient global $K(\Delta T)$ d'impact de capacité électrique, préalablement calculé sur la période temporelle de surveillance, ainsi qu'une valeur mesurée ou estimée de la capacité électrique consommée sur cette période temporelle de surveillance.

La valeur de la consommation électrique est par exemple une consommation totale attendue sur la période temporelle, par exemple une consommation totale par jour, exprimée en mAh (milliampères-heure). Dans un mode de réalisation, la capacité électrique consommée est mesurée par le circuit de surveillance 5 qui fait l'intégration du courant consommé sur la période temporelle. En variante, la consommation électrique consommée totale est estimée par calcul, et la capacité électrique est estimée par intégration de la consommation électrique totale estimée sur la période temporelle.

Si on note Capa(∆T) la valeur mesurée ou estimée de la capacité électrique consommée sur la période temporelle ∆T de surveillance, le coefficient global K(∆T) est appliqué de la manière suivante :

[MATH 2]

$$Capa\_corr\,(\Delta T) = Capa(\Delta T) \times (1 + K(\Delta T))$$

Où Capa_corr(∆T) est la capacité électrique consommée corrigée sur la période, qui permet d'obtenir la capacité résiduelle de la pile, qui est la capacité restant après la période temporelle ∆T, et plus généralement du module de fourniture d'énergie électrique, en fonction de la capacité résiduelle précédente :

[MATH 3]

$$Capacité \leftarrow Capacité - Capa\_corr\,(\Delta T)$$

Pour une pile, la capacité résiduelle décroît au fur et à mesure selon la formule [MATH 3], à partir de la capacité initiale.

Pour une batterie, la formule [MATH 3] est appliquée avec la capacité résiduelle précédente, qui prend en compte, le cas échéant, une recharge de la batterie.

Avantageusement, la capacité résiduelle du module de fourniture d'énergie électrique est plus précisément estimée grâce à la manière proposée de prise en compte des fluctuations éventuelles de température.

Le procédé comporte ensuite un traitement 52 de la capacité résiduelle du module de fourniture d'énergie électrique calculée.

Ce traitement 52 comporte par exemple une étape 54 de commande d'affichage d'une information relative à cette capacité résiduelle calculée, par exemple sous forme graphique indiquant un pourcentage de décharge du module de fourniture d'énergie électrique 4 ou sous forme textuelle, sur une interface homme-machine d'un dispositif électronique. La commande d'affichage est alors effectuée en utilisant l'interface de communication 14 de l'équipement 2.

Le traitement 52 comporte en outre une étape 56 de vérification d'atteinte d'un niveau plancher de capacité résiduelle, par exemple exprimé en nombre de jours d'utilisation restants ou en pourcentage de capacité encore disponible. Par exemple, le niveau plancher est égal à 20% de la capacité initiale du module de fourniture d'énergie électrique. Si le niveau plancher est atteint, une alerte est envoyée à un dispositif électronique distant, par exemple un terminal d'utilisateur.

Par exemple, une alerte textuelle, sous forme de message est envoyée à un terminal d'utilisateur.

Ainsi, avantageusement, une maintenance prédictive est facile à mettre en oeuvre, et toute panne de fonctionnement de l'équipement alimenté par le module de fourniture d'énergie électrique 4 est évitée.

## Revendications

1. Procédé de calcul de capacité d'un module de fourniture d'énergie électrique (4), ledit module étant une pile ou une batterie électrique, ledit module de fourniture d'énergie électrique (4) étant intégré dans un équipement électronique (2), ledit équipement électronique (2) comportant ou étant adapté pour recevoir des mesures de température d'un capteur de température (6), le procédé étant **caractérisé en ce qu'**il comporte des étapes, mises en oeuvre par un processeur de calcul (10), de :

   - sur une période temporelle de surveillance prédéterminée, obtention (42) d'une pluralité de mesures de température, et pour chaque mesure de température, calcul (44) d'un coefficient d'impact de capacité électrique en fonction d'un modèle (28) pré-enregistré, et mémorisation (44) dudit coefficient d'impact de capacité électrique calculé ;
   - calcul (48) d'un coefficient global d'impact de capacité électrique sur la période temporelle de surveillance à partir desdits coefficients d'impact de capacité électrique mémorisés ;
   - calcul (50) d'une capacité résiduelle du module de fourniture d'énergie électrique à partir d'une capacité électrique consommée, mesurée ou estimée sur ladite période temporelle de surveillance, le calcul (50) tenant compte dudit coefficient global calculé.

2. Procédé selon la revendication 1, dans lequel le calcul (48) du coefficient global d'impact de capacité électrique sur la période temporelle de surveillance met en oeuvre un calcul de valeur moyenne desdits coefficients d'impact de capacité électrique mémorisés.

3. Procédé selon l'une des revendications 1 ou 2, dans lequel le calcul (50) d'une capacité résiduelle comprend un calcul de capacité électrique consommée corrigée à partir de la capacité électrique consommée mesurée ou estimée et du coefficient global d'impact de capacité électrique.

4. Procédé selon l'une des revendications 1 à 3, dans lequel chaque coefficient d'impact de capacité électrique est représentatif d'un pourcentage de perte de capacité électrique du module de fourniture d'énergie électrique en fonction de la température.

5. Procédé selon l'une des revendications 1 à 4, dans lequel ledit modèle (28) pré-enregistré est calculé (40) à partir de caractéristiques de fonctionnement du module de fourniture d'énergie électrique.

6. Procédé selon l'une quelconque des revendications 1 à 5, comportant une prise en compte d'un profil d'utilisation dudit module de fourniture d'énergie électrique, un modèle associant des coefficients d'impact de capacité électrique et des valeurs de température étant enregistré pour chaque profil d'utilisation considéré.

7. Procédé selon l'une quelconque des revendications 1 à 6, dans lequel ledit modèle (28) pré-enregistré comprend au moins une fonction mathématique définissant le coefficient d'impact de capacité électrique en fonction de la température.

8. Procédé selon la revendication 7, dans lequel ledit modèle est obtenu (40) par une interpolation polynomiale de valeurs de coefficients d'impact de capacité électrique échantillonnées sur une plage de température d'utilisation prévue.

9. Procédé selon l'une quelconque des revendications 1 à 8, comprenant en outre une étape de traitement (52) comprenant une commande (54) d'affichage d'une information relative à la capacité résiduelle du module de fourniture d'énergie électrique sur une interface homme-machine d'un dispositif électronique.

10. Procédé selon la revendication 9, dans lequel l'étape de traitement (52) comporte en outre une vérification (56) d'atteinte d'un niveau plancher de capacité résiduelle, et l'émission d'une alerte en cas d'atteinte dudit niveau plancher.

11. Programme d'ordinateur comportant des instructions logicielles, qui, lorsqu'elles sont exécutées par un dispositif électronique programmable, exécutent un procédé de calcul de capacité d'un module de fourniture d'énergie électrique selon les revendications 1 à 10.

12. Dispositif de calcul de capacité d'un module de fourniture d'énergie électrique (4), ledit module étant une pile ou une batterie électrique, ledit module de fourniture d'énergie électrique (4) étant intégré dans un équipement électronique (2), ledit équipement électronique comportant ou étant adapté pour recevoir des mesures de température d'un capteur de température, ledit dispositif étant **caractérisé en ce qu'**il comporte un processeur de calcul (10) configuré pour mettre en oeuvre :

   - sur une période temporelle de surveillance prédéterminée, un module d'obtention d'une pluralité de mesures de température, et pour chaque mesure de température, un module (20) de calcul d'un coefficient d'impact de capacité électrique en fonction d'un modèle (28) pré-enregistré, et de mémorisation dudit coefficient d'impact de capacité électrique calculé ;
   - un module (24) de calcul d'un coefficient global d'impact de capacité électrique sur la période temporelle de surveillance à partir desdits coefficients d'impact de capacité électrique mémorisés ;
   - un module (26) de calcul d'une capacité résiduelle du module de fourniture d'énergie électrique à partir d'une capacité électrique consommée, mesurée ou estimée sur ladite période temporelle de surveillance, le calcul tenant compte dudit coefficient global calculé.

13. Dispositif selon la revendication 12, comprenant en outre un module (26) de traitement de capacité résiduelle du module de fourniture d'énergie électrique, configuré pour commander un d'affichage d'une information relative à la capacité résiduelle du module de fourniture d'énergie électrique sur une interface homme-machine d'un dispositif électronique et/ou pour vérifier l'atteinte d'un niveau plancher de capacité résiduelle, et pour envoyer une alerte en cas d'atteinte dudit niveau plancher.

**Patentansprüche**

1. Verfahren zum Berechnen der Kapazität eines elektrischen Energieversorgungsmoduls (4), wobei das Modul eine elektrische Zelle oder Batterie ist, wobei das elektrische Energieversorgungsmodul (4) in eine elektronische Ausrüstung (2) integriert ist, wobei elektronische Ausrüstung (2) Temperaturmessungen von einem Temperatursensor (6) umfasst oder angepasst ist, um diese zu erhalten, wobei das Verfahren **dadurch gekennzeichnet ist, dass** es Schritte umfasst, die von einem Rechenprozessor (10) zu Folgendem ausgeführt werden:

   - über eine vorbestimmte Überwachungszeitdauer, Erlangen (42) einer Vielzahl von Temperaturmessungen, und für jede Temperaturmessung, Berechnen (44) eines Koeffizienten der Auswirkung auf die elektrische Kapazität gemäß einem vorgespeicherten Modell (28), und Speichern (44) des berechneten Koeffizienten der Auswirkung auf die elektrische Kapazität;
   - Berechnen (48) eines Gesamtkoeffizienten für die Auswirkungen der elektrischen Kapazität über die Überwachungszeitperiode aus den gespeicherten Koeffizienten für die Auswirkungen der elektrischen Kapazität;
   - Berechnen (50) einer Restkapazität des elektrischen Energieversorgungsmoduls aus einer verbrauchten, gemessenen oder geschätzten elektrischen Kapazität über die Überwachungszeitperiode, wobei das Berechnen (50) den berechneten Gesamtkoeffizienten berücksichtigt.

2. Verfahren nach Anspruch 1, wobei das Berechnen (48) des Gesamtkoeffizienten der Auswirkungen der elektrischen Kapazität über die Überwachungszeitperiode eine Mittelwertberechnung der gespeicherten Koeffizienten der Auswirkungen der elektrischen Kapazität implementiert.

3. Verfahren nach einem der Ansprüche 1 oder 2, wobei die Berechnung (50) einer Restkapazität eine Berechnung einer korrigierten verbrauchten elektrischen Kapazität aus der gemessenen oder geschätzten verbrauchten elektrischen Kapazität und dem Gesamtkoeffizienten für die Auswirkungen der elektrischen Kapazität umfasst.

4. Verfahren nach einem der Ansprüche 1 bis 3, wobei jeder Stoßkoeffizient der elektrischen Kapazität für einen prozentualen Verlust der elektrischen Kapazität des elektrischen Energieversorgungsmoduls abhängig von der Temperatur repräsentativ ist.

5. Verfahren nach einem der Ansprüche 1 bis 4, wobei das vorgespeicherte Modell (28) anhand der Betriebseigenschaften des Moduls zum Bereitstellen elektrischer Energie berechnet (40) wird.

6. Verfahren nach einem der Ansprüche 1 bis 5, umfassend eine Berücksichtigung eines Nutzungsprofils des Moduls zum Bereitstellen elektrischer Energie, wobei für jedes betrachtete Nutzungsprofil ein Modell aufgezeichnet wird, das Stoßkoeffizienten der elektrischen Kapazität und Temperaturwerte miteinander verbindet.

7. Verfahren nach einem der Ansprüche 1 bis 6, wobei das vorgespeicherte Modell (28) mindestens eine mathematische Funktion umfasst, die den temperaturabhängigen Stoßkoeffizienten der elektrischen Kapazität definiert.

8. Verfahren nach Anspruch 7, wobei das Modell durch eine polynomiale Interpolation von Werten von Stoßkoeffizienten der elektrischen Kapazität erlangt (40) wird, die über einen Temperaturbereich der erwarteten Nutzung abgetastet wurden.

9. Verfahren nach einem der Ansprüche 1 bis 8, ferner umfassend einen Verarbeitungsschritt (52), umfassend einen Befehl (54) zur Anzeige von Informationen über die Restkapazität des Moduls zum Bereitstellen elektrischer Energie auf einer Mensch-Maschine-Schnittstelle einer elektronischen Vorrichtung umfasst.

10. Verfahren nach Anspruch 9, wobei der Verarbeitungsschritt (52) ferner eine Überprüfung (56) eines Erreichens einer Untergrenze der Restkapazität und die Ausgabe einer Warnung bei Erreichen dieser Untergrenze umfasst.

11. Computerprogramm, umfassend Softwareanweisungen, die, wenn sie von einer programmierbaren elektronischen Vorrichtung ausgeführt werden, ein Verfahren zum Berechnen der Kapazität eines Moduls zum Bereitstellen elektrischer Energie gemäß den Ansprüchen 1 bis 10 ausführen.

12. Vorrichtung zum Berechnen der Kapazität eines elektrischen Energieversorgungsmoduls (4), wobei das Modul eine elektrische Zelle oder Batterie ist, wobei das elektrische Energieversorgungsmodul (4) in eine elektronische Ausrüstung (2) integriert ist, wobei elektronische Ausrüstung Temperaturmessungen von einem Temperatursensor umfasst oder angepasst ist, um diese zu erhalten, wobei die Vorrichtung **dadurch gekennzeichnet ist, dass** sie einen Rechenprozessor (10) umfasst, der konfiguriert ist, um Folgendes zu implementieren:

   - über eine vorbestimmte Überwachungszeitdauer, ein Erlangungsmodul einer Vielzahl von Temperaturmessungen, und für jede Temperaturmessung, ein Modul (20) zum Berechnen eines Koeffizienten der Auswirkung auf die elektrische Kapazität gemäß einem vorgespeicherten Modell (28), und zum Speichern des berechneten Koeffizienten der Auswirkung auf die elektrische Kapazität;
   - ein Modul (24) zum Berechnen eines Gesamtkoeffizienten für die Auswirkungen der elektrischen Kapazität über die Überwachungszeitperiode aus den gespeicherten Koeffizienten für die Auswirkungen der elektrischen Kapazität;
   - ein Modul (26) zum Berechnen einer Restkapazität des elektrischen Energieversorgungsmoduls aus einer verbrauchten, gemessenen oder geschätzten elektrischen Kapazität über die Überwachungszeitperiode, wobei das Berechnen den berechneten Gesamtkoeffizienten berücksichtigt.

13. Vorrichtung nach Anspruch 12, ferner umfassend ein Modul (26) zum Verarbeiten der Restkapazität des Moduls zum Bereitstellen elektrischer Energie, das konfiguriert ist, um eine Anzeige von Informationen bezüglich der Restkapazität des Moduls zum Bereitstellen elektrischer Energie auf einer Mensch-Maschine-Schnittstelle einer elektronischen Vorrichtung zu steuern und/oder das Erreichen eines Mindestniveaus der Restkapazität zu überprüfen und bei Erreichen des Mindestniveaus einen Alarm zu senden.

**Claims**

1. A method for calculating the capacity of an electricity supply module (4), said module being an electric cell or battery, said electricity supply module (4) being integrated into electronic equipment (2), said electronic equipment (2) comprising or being adapted to receive temperature measurements from a temperature sensor (6), the method being **characterized in that** it comprises the steps, implemented by a calculation processor (10), of:

obtaining (42) a plurality of temperature measurements over a predetermined monitoring period of time, and calculating (44) an impact coefficient of electricity capacity for each temperature measurement based on a prerecorded model (28), and storing (44) said calculated impact coefficient of electricity capacity;
calculating (48) an overall impact coefficient of electricity capacity over the monitoring time period from said stored impact coefficients of electricity capacity; and
calculating (50) a residual capacity of the electricity supply module from a consumed, measured or estimated electricity capacity over said monitoring time period, the calculation (50) taking into account said calculated overall coefficient.

2. The method according to claim 1, wherein the calculation (48) of the overall impact coefficient of electricity capacity over the monitoring time period implements an average value calculation of said stored impact coefficients of electricity capacity.

3. The method according to one of claims 1 or 2, wherein the calculation (50) of a residual capacity comprises a calculation of corrected, consumed electricity capacity from the measured or estimated consumed electricity capacity and the overall impact coefficient of electricity capacity.

4. The method of any of claims 1 to 3, wherein each impact coefficient of electricity capacity is representative of a percentage loss of electricity capacity of the electricity supply module in function of the temperature.

5. The method of any of claims 1 to 4, wherein said prerecorded model (28) is calculated (40) from operating characteristics of the electricity supply module.

6. The method according to any one of claims 1 to 5, comprising taking into account a usage profile of said electricity supply module, with a model, associating impact coefficients of electricity capacity and temperature values, being recorded for each considered usage profile.

7. The method according to any one of claims 1 to 6, wherein said prerecorded model (28) comprises at least one mathematical function defining the impact coefficient of electricity capacity based on the temperature.

8. The method of claim 7, wherein said model is obtained (40) by polynomial interpolation of impact coefficient of electricity capacity values sampled over an expected operating temperature range.

9. The method according to any one of claims 1 to 8, further comprising a processing step (52) comprising a command (54) to display information relating to the residual capacity of the electricity supply module on a human-machine interface of an electronic device.

10. The method according to claim 9, wherein the processing step (52) further comprises a verification (56) of reaching a floor level of residual capacity, and issuing an alert if said floor level is reached.

11. A computer program comprising software instructions, which, when executed by a programmable electronic device, perform a method for calculating the capacity of an electricity supply module according to claims 1 to 10.

12. A device for calculating the capacity of an electricity supply module (4), said module being an electric cell or battery, said electricity supply module (4) being integrated in electronic equipment (2), said electronic equipment comprising or being adapted to receive temperature measurements from a temperature sensor, said device being **characterized in that** it comprises a calculation processor (10) configured to implement:

a module for obtaining a plurality of temperature measurements over a predetermined monitoring period of time, and a module (20) for calculating an impact coefficient of electricity capacity for each temperature measurement based on a prerecorded model (28), and for storing said calculated impact coefficient of electricity capacity;
a module (24) for calculating an overall impact coefficient of electricity capacity over the monitoring time period from said stored impact coefficients of electricity capacity; and
a module (26) for calculating a residual capacity of the electricity supply module from a consumed electricity capacity measured or estimated over said monitoring time period, the calculation taking into account said calculated overall coefficient.

13. The device according to claim 12, further comprising a module (26) for processing the residual capacity of the electricity supply module, configured to control a display of information relating to the residual capacity of the electricity supply module on a human-machine interface of an electronic device and/or to check that a minimum level of residual capacity has been reached, and to send an alert in the event that the said minimum level has been reached.

FIG.1

| | |
|---|---|
| Calcul et mémorisation modèle K(T) | 40 |

Fin de période — 46

| | |
|---|---|
| Relevé $T_n$ | 42 |

| | |
|---|---|
| Calcul et mémorisation modèle $K(T_n)$ | 44 |

| | |
|---|---|
| Calcul K global | 48 |

| | |
|---|---|
| Calcul capacité restante corrigée en fonction de K global | 50 |

| | |
|---|---|
| Commande affichage | 54 |
| Alerte niveau plancher | 56 |

52

## FIG.2

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3077450 A1